Europäisches Patentamt

European Patent Office

Office européen des brevets

(11) Veröffentlichungsnummer: **0 220 455**
**A1**

## (12) EUROPÄISCHE PATENTANMELDUNG

(21) Anmeldenummer: 86112714.0

(22) Anmeldetag: 15.09.86

(51) Int. Cl.⁴: **G02B 6/42** , **H01S 3/098** , **H01S 3/19**

(30) Priorität: 24.09.85 DE 3534016

(43) Veröffentlichungstag der Anmeldung:
06.05.87 Patentblatt 87/19

(84) Benannte Vertragsstaaten:
CH DE FR GB LI

(71) Anmelder: Siemens Aktiengesellschaft Berlin
und München
Wittelsbacherplatz 2
D-8000 München 2(DE)

(72) Erfinder: Heywang, Walter, Prof. Dr.
Schwabener Weg 9a
D-8011 Neukeferloh(DE)

(54) Anordnung zur Kopplung einer Laserdiode und eines Monomode-Lichtwellenleiters.

(57) Es wird eine Anordnung zur Kopplung einer Laserdiode (1) und eines Monomode-Lichtwellenleiters (2) beschrieben, bei der eine Feinjustierung besonders einfach ist. Dazu ist die Laserdiode (1) eine gewinngeführte Diode und im Abstand von der Koppelstelle (11, 21) ist eine Rückkopplungseinrichtung (4) vorgesehen, die einen Teil des in den Lichtwellenleiter (1) eingekoppelten Lichts im Wellenleiter zurück zur Diode leitet. Dadurch wird erreicht, daß der Teil des Lichtwellenleiters zwischen der Koppelstelle und der Rückkopplungseinrichtung mit als Teil des optischen Resonators des Lasers wirkt und sich die Feinjustierung von selbst einstellen kann. Als Rückkopplungseinrichtung können beispielsweise ein in einem Abstand von einigen Mikrometern von der Koppelstelle angeordneter Metallisierungsring der Breite einiger Lichtwellenlängen oder auch mehrere Metallisierungsringe im Sinne einer verteilten Rückkopplung auf einer Monomode-Glasfaser verwendet werden.

EP 0 220 455 A1

## Anordnung zur Kopplung einer Laserdiode und eines Monomode-Lichtwellenleiters

Die vorliegende Erfindung betrifft gemäß dem Oberbegriff des Patentanspruchs 1 eine Anordnung zur Kopplung einer Laserdiode und eines Monomode-Lichtwellenleiters .

Bei der Ankopplung eines Monomode-Lichtwellenleiters, beispielsweise einer Monomode-Glasfaser, an eine Laserdiode muß eine Feinjustierung vorgenommen werden, bei der die aktive lichtemittierende Zone der Diode und der lichtführende Kern der Faser genau aufeinander eingestellt werden. Eine solche Feinjustierung wurde bisher mechanisch-optisch, beispielsweise mit Hilfe eines Mikroskops, vorgenommen.

Aufgabe der Erfindung ist es, eine Anordnung der genannten Art anzugeben, bei der die Feinjustierung besonders einfach ist.

Diese Aufgabe wird nach dem kennzeichnenden Teil des Patentanspruchs 1 dadurch gelöst, daß die Laserdiode eine gewinngeführte Diode ist und daß im Abstand von der Koppelstelle eine Rückkopplungseinrichtung vorgesehen ist, die einen Teil des in den Lichtwellenleiter eingekoppelten Lichts im Wellenleiter zurück zur Diode leitet.

Durch diese Lösung wird erreicht, daß der Teil des Lichtwellenleiters zwischen der Koppelstelle und der Rückkopplungseinrichtung mit als Teil des optischen Resonators des Lasers wirkt. Dies ist Voraussetzung dafür, daß sich die Feinjustierung von selbst einstellen kann, wenn die Diode und die Faser in einer gröberen Justierung aufeinander einjustiert sind. Grund dafür ist, daß in einem "gewinngeführten" ("gain guided", siehe dazu beispielsweise Appl. Phys. Lett. 43 (9), 1.Nov. 1983, S. 809-810) Laser die räumliche Lage der aktiven lichtemittierenden Zone innerhalb des elektrisch angeregten Halbleiterbereichs durch die optimale Erfüllung der optischen Laserbedingung bestimmt ist.

Eine bevorzugte und vorteilhafte Ausgestaltung der erfindungsgemäßen Anordnung ist nach Anspruch 2 so ausgebildet, daß auf den Lichtwellenleiter in Form einer Monomode-Glasfaser in einem Abstand von einigen Mikrometern von der Koppelstelle ein Metallisierungsring der Breite einiger Lichtwellenlängen oder auch mehrere Metallisierungsringe als Rückkopplungseinrichtung aufgebracht sind. Die mehreren Metallisierungsringe sind dabei im Sinne einer verteilten Rückkopplung aufzubringen, d.h. in Lichtausbreitungsrichtung im Wellenleiter nacheinander.

Anstelle oder zusätzlich zu den Ringen können auch Kerben in der Oberfläche der Glasfaser vorgesehen sein, die beispielsweise durch Ätzen erzeugt werden können. Jede Kombination aus Ringen und Kerben ist möglich.

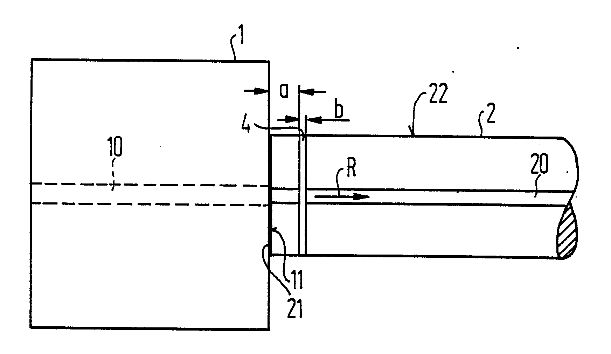

Die Erfindung wird anhand der Figur näher erläutert.

Die Figur zeigt eine Draufsicht auf eine - schematisch dargestellte Anordnung zur Kopplung einer gewinngeführten Laserdiode und einer Monomode-Glasfaser, bei der die Diode und die Faser stirnflächengekoppelt sind. Die Darstellung ist nicht maßstäblich.

Bei der dargestellten Anordnung ist die Laserdiode 1 schematisch als Block dargestellt. Das Licht tritt aus der Stirnfläche 11 der Diode 1 aus. Dieser Stirnfläche 11 liegt die Stirnfläche 21 der Monomode-Glasfaser 2 gegenüber, durch die das Licht in die Faser 2 eingekoppelt wird. Die Einkopplung erfolgt im wesentlichen nur im Bereich des Kerns 20 der Faser 2, in dem auch im wesentlichen das Licht geführt wird.

Im Abstand a von der durch die beiden Stirnflächen 11 und 21 definierten Koppelstelle, der beispielsweise von der Stirnfläche 21 der Faser 2 aus gemessen werden kann, ist ein Metallisierungsring 4 der Breite b auf der äußeren Mantelfläche 22 der Faser 2 aufgebracht. Der Abstand a kann beispielsweise einige Mikrometer, die Breite b beispielsweise einige Wellenlängen des von der Diode 1 abgestrahlten Lichts getragen.

Der Metallisierungsring 4 bildet eine Rückkopplungseinrichtung, die einen Teil des in die Faser 2 eingekoppelten und im wesentlichen im Kern geführten und in Richtung R sich ausbreitenden Lichts in die Faser zur Diode zurückleitet. Dadurch wirkt der zwischen der Stirnfläche 21 und dem Metallisierungsring 4 liegende Anfangsteil der Faser 2 mit als Teil des optischen Resonators der Diode 1. Dies hat zur Folge, daß sich die aktive lichtemittierende Zone 10 innerhalb des elektrisch angeregten Halbleiterbereichs von selbst fein auf den Kern 20 der Faser 2 einjustiert. Es ist nur dafür zu sorgen, daß der Kern 20 in einer gröberen Justierung in den elektrisch angeregten Halbleiterbereich gebracht wird.

## Ansprüche

1. Anordnung zur Kopplung einer Laserdiode und eines Monomode-Lichtwellenleiters, **dadurch gekennzeichnet**, daß die Laserdiode (1) eine gewinngeführte Diode ist und daß im Abstand (a) von der Koppelstelle (11, 21) eine Rückkopplungseinrichtung (4) vorgesehen ist, die einen Teil des in den Lichtwellenleiter eingekoppelten Lichts im Wellenleiter (2) zurück zur Diode leitet.

2. Anordnung nach Anspruch 1, **dadurch gekennzeichnet,** daß der Monomode-Lichtwellenleiter (2) aus einer Glasfaser besteht, auf der in einem Abstand (a) von einigen Mikrometern von der Koppelstelle (11, 21) ein Metallisierungsring der Breite (b) einiger Lichtwellenlängen oder auch mehrere Metallisierungsringe und/oder eine oder mehrere Kerben als Rückkopplungseinrichtung (4) angebracht sind.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | US-A-3 803 511 (G.H.B. THOMPSON) <br> * Patentansprüche 1-4; Figuren * | 1,2 | G 02 B 6/42 <br> H 01 S 3/098 <br> H 01 S 3/19 |
| X | DE-A-2 750 322 (HITACHI) <br> * Patentansprüche 1-3; Seite 5, Zeilen 20-25; Figuren 3-6 * | 1,2 | |
| A | FR-A-2 310 580 (PHILIPS) <br> * Patentanspruch; Figuren * | 1 | |
| A | EP-A-0 150 749 (A.T.T.C.) <br> * Seite 3, Zeilen 6-25; Patentanspruch 1 * | 1 | |
| A | ELECTRONICS LETTERS, Band 19, Nr. 19, 15. September 1983, Seiten 750,751, London, GB; K.-Y. LIOU: "Single-longitudinal-mode operation of injection laser coupled to a grinrod external cavity" <br> * Das ganze Dokument * | 1 | RECHERCHIERTE SACHGEBIETE (Int. Cl.4) <br><br> G 02 B <br> H 01 S |

Der vorliegende Recherchenbericht wurde für alle Patentansprüche erstellt.

| Recherchenort | Abschlußdatum der Recherche | Prüfer |
|---|---|---|
| DEN HAAG | 08-01-1987 | PFAHLER R. |